# EUROPEAN PATENT APPLICATION

(11) **EP 0 848 299 A2**
(43) Date of publication of application: **17.06.1998**
(21) Application number: 97310110.8
(22) Date of filing: 15.12.1997
(51) Int. Cl.: G03F 9/00, G03F 7/20

(54) **Stage and optical projection apparatus**

(30) Priority: 16.12.1996 JP 353269/96
(71) Applicant: NIKON CORPORATION, Tokyo (JP)
(72) Inventor: Kaneko, Kenichiro, c/o Nikon Corporation, Chiyoda-ku, Tokyo (JP)
(74) Representative: Rackham, Stephen Neil

(57) **Abstract**

When a material support is moved along with a stage (18), coordinates of the position of the material support are measured by a measuring device (26). Displacement of the material support in the Z-direction as caused by the movement of the stage (18) is stored in the storage (36) in association with coordinates of corresponding position of the material support. When the flatness measurement is performed on a material piece placed on the material support while the stage (18) is moved, the amount of such displacement of the material support in the Z-direction that is indicated by the displacement data in the storage and corresponds to the current position of the material support at each measurement point, may be read out from the storage and used as correction amount for correcting the position of the material support in the Z-direction. In this manner, the flatness may be performed with the correction thus effected.

## Description

The present invention relates to a stage apparatus and a projection optical apparatus. More particularly, the present invention relates to a stage apparatus including a material support capable of positioning a material piece carried thereon with at least three degrees of freedom, and to a projection optical apparatus including such a stage apparatus used as a positioning stage for a material piece. One representative example of such a projection optical apparatus is a projection exposure apparatus, such as a stepper, for use in a photolithographic process forming a part of the fabrication process of semiconductor devices, liquid crystal displays or other products. Another example is lens inspection equipment for measuring various aberrations associated with a projection optical system (or projection lens) equipped for such a projection exposure apparatus.

In photolithographic process for fabricating semiconductor devices, liquid crystal displays or other products, there have been used various projection exposure machines in which an exposure light beam is used to illuminate a mask or a reticle (a generic term "reticle" is used to mean either hereinafter) so as to transfer a pattern formed on the reticle through a projection optical system onto a photosensitized substrate. Further, in order to measure aberrations associated with a projection optical system equipped for such a projection exposure machine, there has been used lens inspection equipment in which various aberrations with the projection optical system are measured by making a projection exposure so as to transfer an image of a reticle pattern onto a photosensitized substrate and analyzing the exposure result (or the resulting pattern image formed on the photosensitized substrate.)

With these machines and equipment, a stage apparatus is typically used for positioning a material piece or substrate having a photosensitive layer coated on its surface. The substrate may typically comprise a silicon wafer or a glass plate (referred to simply as a "wafer" hereinafter). One common stage apparatus comprises an XY-stage capable of two-dimensional movement in a plane (typically, an XY-plane) and a material support (or Z-stage) for supporting a material piece or wafer thereon, the material support being mounted on the XY-stage and capable of displacing in the Z-direction perpendicular to the XY-plane.

By way of example, consider a demagnification projection exposure apparatus of the step-and-repeat type (commonly referred to as a "stepper"). In an exposure apparatus of this type, after the exposure of a shot-area, the wafer is moved or stepped to the next shot-area and the process is repeated until the entire surface of the wafer (or every shot-area on the wafer) has been processed to have reticle patterns transferred onto it. The stepping movement of the wafer is produced by the two-dimensional movement or translation of the XY-stage supporting that wafer.

With recent progress in the microminiaturization of circuit patterns exposure apparatuses are required to provide higher performance including an improved overlay accuracy as well as a higher resolution. Because a typical demagnification exposure apparatus uses a projection lens having a large numerical aperture (NA), its depth of focus is so small that a certain, appropriate mechanism must be provided for bringing with precision the surface of the wafer to a position at which it will be coincident with the image plane of the reticle pattern defined by the projection lens (such a mechanism may be, for example, an auto-focussing mechanism or a levelling mechanism). Also, it is desired to measure minute irregularities in the nominally flat surface of a wafer, or variation in height of the surface of a wafer placed on the stage among different points on the wafer surface. That is, wafer-flatness measurement is desired. Further, it is also desired to measure with accuracy various aberrations (such as, variation in depth of focus, curvature of image plane, tilt of image plane and others) associated with a projection optical system.

Wafer-flatness measurement, as well as the measurement of aberrations with the projection lens by lens inspection equipment, have been typically performed by using the positions of the moving XY-stage as the reference for the measurement. Specifically, in the case of wafer-flatness measurement, the XY-stage is driven so as to sequentially move the wafer into a number of predetermined measurement points arranged in a rectangular array or matrix, and the height (or the position in the Z-direction) of the surface of the wafer is measured at each measurement point. The Z-direction is perpendicular to the plane in which the XY-stage moves and is usually defined as the direction along the optical axis of the projection optical system.

Unfortunately, the surface of the wafer or material piece carried by the XY-stage may rise and sink (or displace in the Z-direction) while the XY-stage is driven (or more exactly an X-stage and/or a Y-stage, together composing the XY-stage, are driven) to move the wafer in the XY-plane. In the case where the drive mechanism for the stage comprises a feed screw in threading engagement with the stage and an electric motor for rotating the feed screw, such displacement in the Z-direction may be possibly caused by various factors, including minute irregularities in the nominally flat bearing surface along which the stage is guided, an inevitable play between the feed screw and the stage engaging with each other, some distortion induced in the feed screw, and others.

Therefore, the rise/sink of the stage produced when the stage is moved into different positions, or the displacement characteristic of the stage, often causes errors in the results of the wafer-flatness measurement and the lens-aberration measurement. Further, unlike the yaw of wafers which may be separately measured with ease by a yaw-measuring interferometer, it has been impossible to separately measure the displacement characteristic of the stage (or the rise/sink of the stage), with the result that the wafer-flatness measurement and the lens-aberration measurement have been performed so far, allowing for such errors.

Nevertheless, with the continuing increase in the complexity of present-day integrated circuits (ICs), the measurement errors caused by an undesirable displacement characteristic of the stage are becoming unacceptable, and it is almost certain that such measurement errors are not acceptable for the fabrication of the next generation of 64-megabit dynamic random access memories (DRAMs) any longer.

In view of the foregoing, it is an object of the present invention to provide a stage apparatus which may provide an improved measurement accuracy in various measurement processes in which the positions of the moving stage are used as a reference for the measurement.

It is another object of the present invention to provide a stage apparatus which is capable of correcting for the rise/sink of the stage during such a measurement process.

It is a further object of the present invention to provide a stage apparatus which may improve measurement accuracy with the positions of the moving stage being used as the reference for the measurement.

It is a yet further object of the present invention to provide a projection optical apparatus which is capable of performing various measurement processes in which the positions of the moving stage are used as the reference for the measurement, such as the flatness measurement of a substrate, with great precision.

In accordance with the present invention, there is provided a stage apparatus comprising: a first stage movable in two orthogonal directions in a predetermined plane; a material support mounted on the first stage and capable of minute displacement in the direction along a first axis perpendicular to the predetermined plane; a measuring device for measuring coordinates of the position of the material support mounted on the first stage in the two orthogonal directions; and a storage for storing displacement data indicative of displacement of the material support in the direction along the first axis, as caused by movement of the first stage, in association with coordinates of corresponding position of the material support.

In this stage apparatus, when the material support is moved along with the first stage, the coordinates of the position of the material support are measured by the measuring device. At the same time, displacement of the material support in the direction along the first axis as caused by the movement of the first stage is stored in the storage in association with coordinates of corresponding position of the material support.

Therefor, when for example flatness measurement of a material piece placed on the material support is performed while the stage is moved, such displacement of the material support in the direction along the first axis that is indicated by the displacement data in the storage and corresponds to the current position of the material support at each measurement point, may be read out from the storage and used as correction amount for correcting the position of the material support in the direction along the first axis. Thus, the flatness measurement may be performed with the correction thus effected. Alternatively, after the flatness measurement process is completed, the results of the measurement (i.e., the measured distance of the surface of the material piece from a reference point, as measured in the direction along the first axis at each measurement point) may be corrected using the displacement data in the storage. In either case, the measurement accuracy of the flatness measurement process may be improved. For a similar reason, measurement of aberrations associated with a projection lens may be performed with high accuracy as well.

Further, with the stage apparatus above, the displacement data stored in the storage may be any of data indicative of displacements of the material support in the direction along the first axis corresponding to a number of positions of the material support, irrespective of the method of performing the measurement. More particularly, the displacement data stored in the storage may be data as derived by arithmetic operation from a distance data indicative of a distance of a surface of a plane-parallel surface-mirror placed on the material support from a predetermined reference point, as measured in the direction along the first axis at each of measurement points while the first stage is moved with step intervals in the predetermined plane. In this case, it is preferable to measure, in advance, the flatness of the surface of the plane-parallel surface-mirror by an appropriate surface shape measuring device, such as a Fizeau interferometer.

In addition, correction to the results of the flatness measurement process may be effected after the flatness measurement process itself is completed as with a conventional correction method, by subtracting correction amount (derived from the displacement data stored) at the corresponding position in the predetermined plane, from the measured value at each measurement point. Alternatively, correction may be made by correcting the position of the material support in the direction along the first axis through a real-time correction operation using the correction amount just measured, during the flatness measurement process. In the latter case, it is preferable that the stage apparatus may further comprise an adjustor for adjusting, while the first stage is moved, the position of the material support in the direction along the first axis, depending on the amount of such displacement of the material support in the direction along the first axis that is indicated by the displacement data and that corresponds to the current position of the material support. In this arrangement, the position of the material support in the direction along the first axis may be corrected depending on the amount of such displacement of the material support that corresponds to the current position of the material support by means of the adjustor. Therefore, the flatness measurement process and other measurement processes may be performed under an ideal condition effectively with no rise/sink of the first stage, and thus with great precision.

Moreover, it is also preferable that the stage apparatus may further comprise an arithmetic operation device for performing interpolation on the displacement data in the storage to derive the amount of such displacement of the material support in the direction along the first axis that corresponds to the current position of the material support, when the first stage has been moved to such a position for which the displacement data in the storage contains no indication of displacement.

With this arrangement, even when the first stage has been moved to such a position for which the displacement data stored in the storage contains no indication of displacement, such displacement of the first stage in the direction along the first axis that corresponds to the current position of the material support may be derived by means of the arithmetic operation device. As the result, displacement of the material support in the direction along the first axis may be corrected, or eliminated by adjustment, not only at the positions of the first stage for which the displacement data in the storage contains indications of displacement, but also at any other positions of the first stage into which it may be moved. Thus, the measurement accuracy in the flatness measurement or other measurements may be further improved. In addition, this effectively reduces the number of necessary data values to be stored in advance in the storage, so that displacement measurement steps at reduced measurement points are sufficient for the purpose, resulting in a reduced time for the measurement procedure.

In accordance with the present invention, there is also provided a projection optical apparatus comprising: a stage apparatus for supporting a substrate; a mask having a pattern formed thereon; an illumination system for illuminating the mask with an exposure light beam; a projection optical system for projecting the pattern formed on the mask onto the substrate with the exposure light beam; and the stage apparatus having: a first stage movable in two orthogonal directions in a predetermined plane; a material support for supporting a substrate, the material support being mounted on the first stage and capable of minute displacement in the direction along a first axis perpendicular to the predetermined plane; a measuring device for measuring coordinates of the position of the material support mounted on the first stage in the two orthogonal directions; and a storage for storing displacement data indicative of displacement of the material support in the direction along the first axis, as caused by movement of the first stage, in association with coordinates of corresponding position of the material support.

With the projection optical apparatus above, by virtue of provision of the stage apparatus for use as a stage for positioning the photosensitized substrate, correction may be effected to the position of the material support and/or the measured values obtained through the flatness measurement process and other measurement processes based on the displacement data stored in the storage and indicative of displacements of the material support in the direction along the first axis at a number of measurement points. Thus, the measurement accuracy with the flatness measurement process performed on the photosensitized substrate placed on the material support may be improved. For a similar reason, the measurement of aberrations with a projection lens may be performed with great accuracy as well.

The above and other objects, features and advantages of the present invention will be apparent from the following detailed description of preferred embodiments thereof, reference being made to the accompanying drawings, in which:
Fig. 1 is a schematic of a projection exposure apparatus according to an embodiment of the present invention, showing an implementation thereof for exposure process;
Fig. 2 is a schematic of the apparatus of Fig. 1, showing an implementation thereof for data acquisition process for data to be stored in a storage device of Fig. 1;
Fig. 3 illustrates a typical displacement of the material support of Fig. 1 in the Z-direction as produced when the XY-stage of Fig. 1 is moved in the direction along the Y-axis; and
Fig. 4 illustrates a typical displacement of the material support as produced when the XY-stage is moved in the direction along the Y-axis, together with a number of measurement points arranged in a rectangular array or matrix.

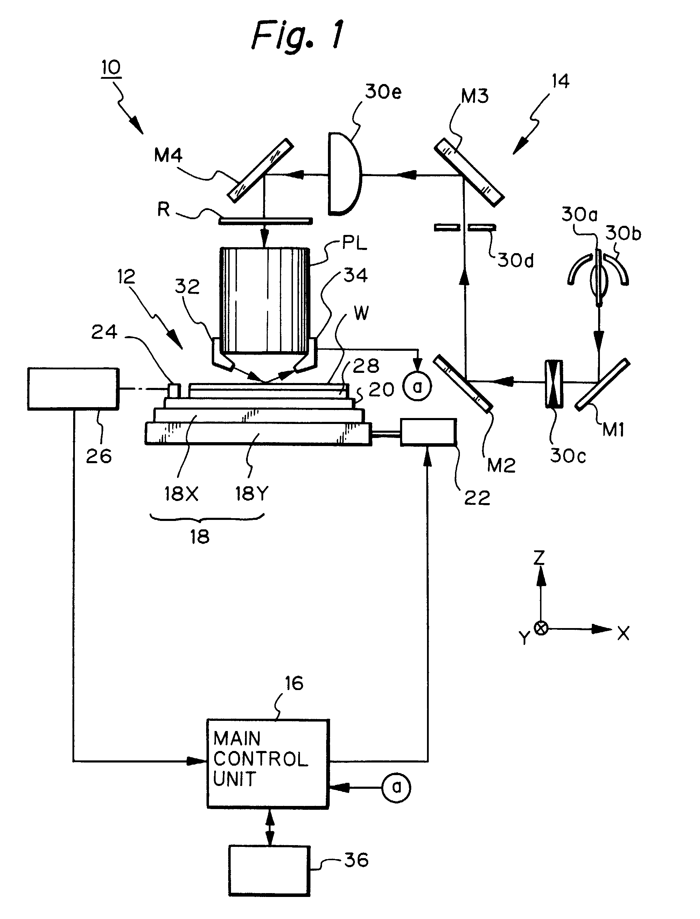

Referring now to Figs. 1 to 4 of the accompanying drawings, preferred embodiments of the present invention will be described in detail.

Fig. 1 is a schematic of a projection exposure apparatus 10 according to an embodiment of the present invention, which is a representative of various projection optical apparatus with which a stage apparatus according to the present invention may be used. The projection exposure apparatus 10 includes a wafer stage 12 for carrying thereon a photosensitized substrate or wafer W, a projection optical system PL disposed above the wafer stage 12, a master matrix of a pattern or reticle R held on a reticle holder (not shown) and disposed above the projection optical system PL, an illumination system 14 for illuminating the reticle R with an exposure light beam, and a main control unit 16 for providing general control of the entire projection exposure apparatus 10.

The wafer stage 12 comprises a first stage or XY-stage 18, which in turn comprises a Y-stage 18Y supported on a base (not shown) and movable in the Y-direction (perpendicular to the drawing sheet surface of Fig. 1) and an X-stage 18X supported on the Y-stage 18Y and movable in the X-direction (left-to-right direction as viewed in Fig. 1) perpendicular to the Y-direction. The wafer stage 12 further comprises a material support 20 carried on the X-stage 18X and movable in the Z-direction (perpendicular to the XY-plane) within a predetermined displacement range of, for example, 100 µm. The Y-stage 18Y, the X-stage 18X and the material support 20 are driven by means of a drive unit 22 for their movements in their own moving directions. The drive unit 22 includes a pair of drive mechanisms, one for each of the Y-stage 18Y and the X-stage 18X. The drive mechanism comprises a combination of a feed screw and an electric motor for rotating the feed screw. The drive unit 22 further includes a third drive mechanism (not shown) associated with the material support 20 for driving it to move or displace in the Z-direction. The material support 20 and the associated drive mechanism together constitute a Z-stage for driving or displacing the wafer W on the material support 20 in the Z-direction. The drive mechanism associated with the material support 20 includes a built-in encoder for measuring the displacement of the material support 20 in the Z-direction, and the drive unit 22 uses the measured values output from the encoder when it drives the material support 20 in the Z-direction.

A pair of movable mirrors 24 (only one of them is shown in Fig. 1) are fixedly mounted on the material support 20. A pair of corresponding position-measuring devices or laser interferometer units 26 (again only one of them is shown in Fig. 1) are disposed each facing the associated one of the movable mirrors 24 for emitting a measuring beam (laser beam) toward the associated movable mirror 24 and using the reflection beam therefrom to measure the position of the material support 20 in the direction along its measuring beam. Specifically, the movable mirrors 24 include an X-direction movable mirror having its mirror surface extending perpendicular to the X-axis and a Y-direction movable mirror having its mirror surface extending perpendicular to the Y-axis. Similarly, the interferometer units 26 include an X-direction laser interferometer unit for measuring the position of the material support 20 in the X-direction and a Y-direction laser interferometer unit for measuring the position of the material support 20 in the Y-direction. However, in Fig. 1, only one movable mirror 24 and only one interferometer unit 26 are shown as representatives of the pairs. Thus, in the following description, it is assumed that the shown combination of the laser interferometer unit 26 and the movable mirror 24 provides the measurements of the two-dimensional, XY-coordinates of the position of the material support 20 with a high resolution of, for example, 0.01 µm. The measurements from the laser interferometer 26 are supplied to the main control unit 16.

A wafer holder 28 is mounted on the material support 20. The material piece or wafer W is held on the wafer holder 28 by means of vacuum suction, which may be provided, for example, by a vacuum chuck.

The illumination system 14 comprises a mercury lamp 30a serving as an illumination light source, an ellipsoidal reflector 30b, mirrors M1, M2, M3 and M4, a shutter 30c, a blind 30d, a condensor lens 30e and other elements not shown for simplicity. In operation, briefly, the mercury lamp 30a emits illumination rays, which are collected by the ellipsoidal reflector 30b into the region around the secondary focal point of the ellipsoidal reflector 30b. From the collected rays, only light of a selected wavelength for exposure purpose is passed through a suitable wavelength selector element (not shown) to form an illumination light beam, which then strikes on and is reflected by the mirror M1 into the shutter 30c. The wavelength may be selected, for example, to 364 nm where the light of i-line from the mercury lamp output should be used. When the shutter 30c is open, the illumination light beam (which is also an exposure light beam) is allowed to pass through the shutter 30c and reflected by the mirror M2 into an optical integrator (not shown) which may comprise a fly's eye lens. The illumination beam then passes through the blind 30d, is reflected by the mirror M3, passes through a relay lens system (not shown) and through the condensor lens 30e, and is again reflected by the mirror M4 to illuminate the reticle R. The optical integrator serves to improve uniformness in illuminance over the entire surface of the reticle R. The blind 30d is disposed at a position which is conjugate to the position of the pattern bearing surface of the reticle R and has an aperture which defines the outline of the illumination area produced on the surface of the reticle R.

As described, the reticle R is held on the reticle holder (not shown). The position of the reticle R is adjustable within an XY-plane by means of an adjustor mechanism (not shown). The reticle R has a circuit pattern (not shown) drawn on the under surface thereof, which extends in a plane which will be substantially, optically conjugate to the plane of the surface of the wafer W.

The projection optical system PL is mounted on and supported by a body column (not shown) of the projection exposure apparatus 10, with its optical axis extending in the Z-direction. The projection optical system PL used in the disclosed embodiment has double-side telecentricity with a selected demagnification ratio β (which may be selected, for example, to 1/4 or 1/5). Thus, when the reticle R is illuminated with the illumination beam from the illumination system 14, with the alignment between the reticle R and the wafer W been established, a reduced image of the pattern on the reticle is projected through the projection optical system PL onto the photoresist-coated wafer W for making exposure.

A focus detection system of the oblique incidence type is disposed by the projection optical system PL and comprises a light-beam-sending unit 32 and a light-beam-receiving unit 34. The focus detection system (32, 34) serves to measure the displacement of the surface of the wafer W in the direction along the optical axis of the projection optical system PL (thus, the displacement is the out-of-focus distance.) The detection signals output from the focus detection system (32, 34) are supplied to the main control unit 16.

The main control unit 16 comprises a microcomputer (alternatively, it may comprise a minicomputer) including a central processing unit (CPU), a read-only memory (ROM), a random-access memory (RAM) and other known components. The main control unit 16 controls the position of the XY-stage while monitoring the measurements from the laser interferometers 26, performs the wafer-flatness measurement process (described later in detail), controls the exposure operation, as well as provides other functions.

Further, with the projection exposure apparatus 10 according to the disclosed embodiment, the main control unit 16 is provided with a storage device 36 serving as storage means with a relatively great capacity. This storage device 36 is used to store the data indicative of displacement characteristic of the XY-stage in association with XY-coordinates of corresponding position of the material support, or the displacements of the material support 20 in the Z-direction corresponding to the positions of the material support 20 in the XY-plane. The values of such displacements, or the displacement data, are measured in advance in the manner described later, and stored in the storage device 36. The displacement data is read out from the storage device 36 by the CPU in the main control unit 16 and used for various measurement purposes. The displacement data may be used for the wafer-flatness measurement process, as described later, in order that the position of the material support 20 in the Z-direction should be corrected for such displacement through the drive unit 22.

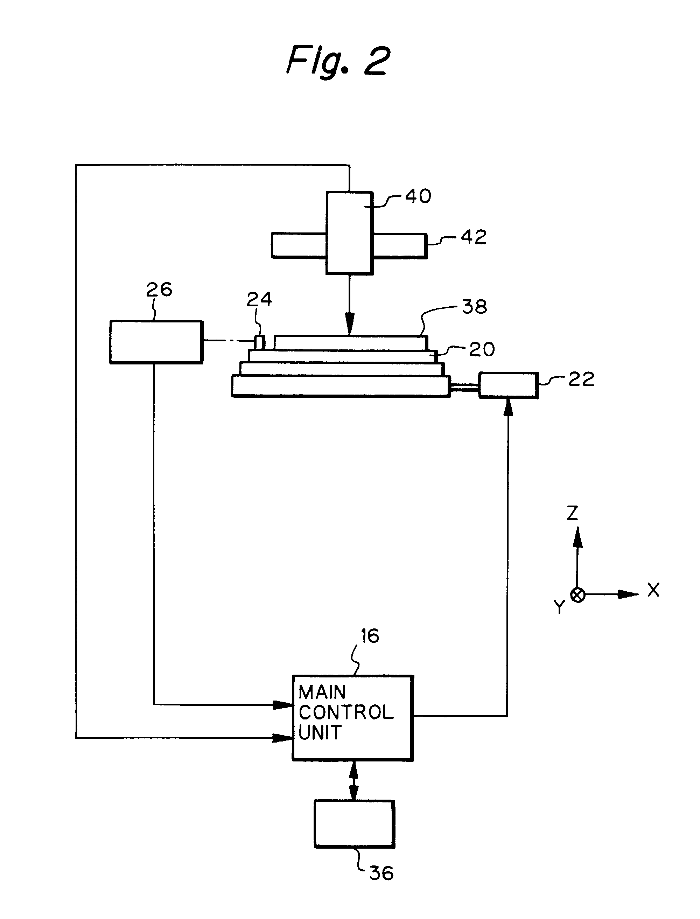

Referring next to Figs. 2 to 4, one exemplified method of measuring the displacement characteristic of the XY-stage 18 to be stored in the storage device 36 will be described in detail.

The measurement of the displacement characteristic of the XY-stage 18 is conducted before the projection optical system PL and the focus detection system (32, 34) are mounted to the projection exposure apparatus 10. Fig. 2 is a schematic of the projection exposure apparatus 10, showing an implementation thereof for this measurement. It is noted that the illumination system 14 has been already mounted to the projection exposure apparatus 10, but is not shown in Fig. 2 for simplicity.

As shown in Fig. 2, a reference mirror 38 is placed on the material support 20 instead of the wafer holder 28 with a wafer W thereon (Fig. 1). The reference mirror 38 comprises a plane-parallel surface-mirror having very high flatness of surfaces and with the upper surface thereof formed as a mirror surface. A distance-measuring laser interferometer unit 40 is disposed above the reference mirror 38 at a position which will be later occupied by the projection optical system PL. The laser interferometer unit 40 serves to measure the position in the Z-direction, and thus is referred to as the "Z-direction interferometer unit" hereinafter. The Z-direction interferometer unit 40 is mounted on the body column (not shown) through a fixture tool 42, with its measuring direction set in the Z-direction. The measurements output from the Z-direction interferometer unit 40 are supplied to the main control unit 16.

In order to measure the displacement characteristic of the XY-stage 18, the CPU in the main control unit 16 follows predetermined routines programmed and stored in the ROM so as to drive the XY-stage 18 along with the material support 20 through the drive unit 22 to cause two-dimensional movement of the material support 18 in the X-direction and/or Y-direction. In the two-dimensional movement of the XY-stage 18 (and thus of the material support 20), the XY-stage 18 is moved with predetermined step intervals in the XY-plane such that the material support 20 is sequentially positioned to a number of predetermined measurement points arranged in a rectangular array or matrix. For the positioning of the material support 20 to the measurement points the CPU monitors the measurements output from the laser interferometers 26, while it also measures the displacement of the material support 20 in the Z-direction in relation to its two-dimensional position in the XY-plane. Accordingly, the main control unit 16 reads the measured value output from the Z-direction interferometer 40 when the material support 20 is positioned at each measurement point and stores the measured value (indicative of the distance in the Z-direction from a reference pint) in the storage device 36 in association with XY-coordinates of the corresponding position of the material support 20 indicated by the outputs of the laser interferometers 26.

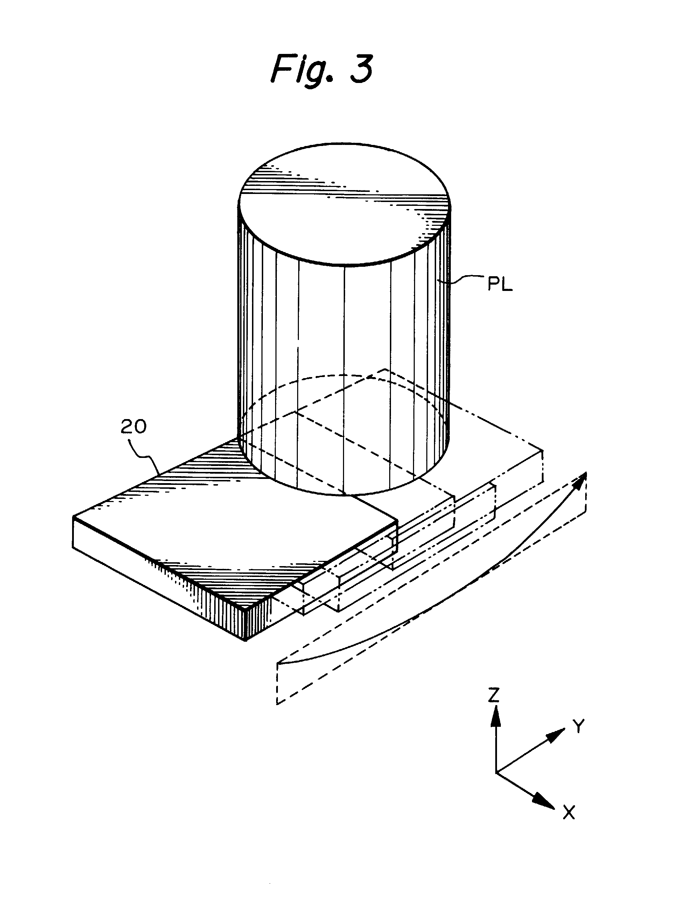

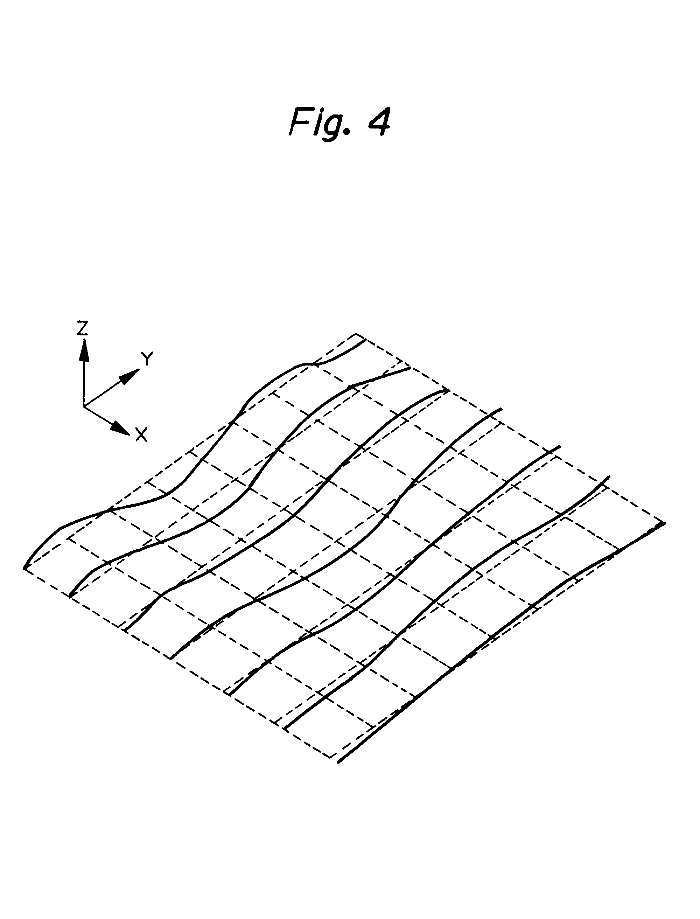

When the above measurement process is completed, displacement data has been obtained comprising the values of rise/sink of the material support 20 as caused by movement of the XY-stage 18 (and thus of the material support 20) and corresponding to the positions of the measurement points. Typical rise/sink of the material support 20 thus causes is schematically shown in Fig. 3 with exaggeration, together with the projection lens PL. An example of the rectangular array or matrix of the measurement points are shown in Fig. 4 in which intersections between broken lines are the predetermined measurement points. The displacement data indicative of the displacements of the material support 20 in the Z-direction that correspond to respective positions of the material support 20 in the XY-plane, which would also correspond to the predetermined measurement points, is stored in the storage device 36 in association with the XY-coordinates of the corresponding positions of the material support 20. The data may be stored in any appropriate form, such as a look-up table.

The solid-line curves in Fig. 4 visually illustrate, by way of example, how the rise/sink of the XY-stage 18 would be measured through the above measurement process.

The displacement characteristic of the XY-stage 18 can be measured more exactly if the distance between two adjacent measurement points (indicated as intersections between broken lines in Fig. 4) is reduced to increase the number of the measurement points. This may require, however, a longer time to complete the measurement process for acquisition of the displacement data, which may be possibly disadvantageous.

In order to avoid an unacceptable increase in the number of the measurement points, it is preferable that the main control unit 16 should perform arithmetic operation on the measured values in the displacement data obtained at a limited number of measurement points, by interpolating between measured values at adjacent measurement points using an appropriate interpolation technique, such as approximate functional interpolation, linear interpolation and spline interpolation, so that displacement values of the material support 20 in the Z-direction for the additional points in the XY-plane distributed over the entire moving range of the XY-stage 18 may be derived. Then, the values thus derived can be stored in the storage device 36 in association with the coordinates of the corresponding positions of the material support 20 in the XY-plane. In this manner, displacement data approximating the actual rise/sink of the XY-stage 18, such as shown in Fig. 4 by solid-line curves, may be obtained without consuming a long time for the measurement process for acquisition of displacement data.

It is further preferable that the irregularities in the shape of the nominally flat top surface of the reference mirror 38 are measured through an appropriate surface shape measuring means, such as a Fizeau interferometer, before the measurement process for acquisition of the displacement data. Then, the displacement values, whether measured or derived by interpolation, are corrected for the measured irregularities (by subtracting/adding the irregularity values from/to the displacement values for the corresponding XY-coordinates) before the displacement data is stored in the storage device 36. More specifically, this may be preferably performed by placing the reference mirror 38 on the material mirror 20 as would be in the process of the measurement for displacement data acquisition, using a Fizeau interferometer to conduct the measurement process for acquisition of the data indicative of the irregularities in the surface shape of the reference mirror 38 (or surface-shape data), and storing this surface-shape data either in the storage device 36 or in appropriate storage locations in the RAM in association with the XY-coordinates of the measurement points from an arbitrarily chosen reference point.

Referring again to Fig. 1, the operation steps for the wafer-flatness measurement process conducted with the projection exposure apparatus 10 of the disclosed embodiment having the above-described arrangement will be described in detail.

As with the measurement process for displacement data acquisition (i.e., for the displacement characteristic of the XY-stage 18), the CPU in the main control unit 16 follows predetermined routines programmed and stored in the ROM so as to drive the XY-stage 18 along with the material support 20 through the drive unit 22 to cause two-dimensional movement of the material support 18 in the X-direction and/or Y-direction. In the two-dimensional movement of the XY-stage 18 (and thus of the material support 20), the XY-stage 18 is moved with predetermined step intervals in the XY-plane such that the material support 20 is sequentially positioned to a number of predetermined measurement points arranged in a rectangular array or matrix. For the positioning of the material support 20 to the measurement points the CPU monitors the measurements output from the laser interferometers 26. Further, the main control unit 16 reads the measured value output from the focus detection system (32, 34) when the material support 20 is positioned at each measurement point. Before reading the measured value, the main control unit 16 retrieve the displacement value corresponding to that measurement point (or corresponding to the current position of the material support 20 indicated in terms of XY-coordinates, as seen from the current measured values output from the laser interferometers 26) contained in the displacement characteristic of the stage (or the data of displacement in the Z-direction) stored in the storage device 36. The retrieved displacement value is used as the correction amount, such that the drive unit 22 is so controlled as to adjust the position of the material support 20 in the Z-direction to correct for the displacement, and thereby prevent the rise/sink of the XY-stage 18 from affecting the position of the material support 20 in the Z-direction. In order to retrieve from the storage device 36 the displacement value in the displacement characteristic of the stage that corresponds to the measured values output from the laser interferometers 26, the main control unit 16 may use any suitable retrieval technique. For example, appropriate equations showing the relation between the storage locations for displacement values and the XY-coordinates of the positions corresponding to the displacement values may be used. Alternatively, an appropriate look-up table may be used to narrow the area of storage locations to be scanned for retrieval of the desired displacement value. Further, any other quick retrieval techniques may be also used.

After the retrieved value is used to adjust the position of the material support 20 in the Z-direction, the main control unit 16 reads the measured value (or the defocus signal) output from the focus detection system (32, 34) and store it in the storage device 36 in association with the corresponding measured values output from the laser interferometers 26.

In this manner, accurate wafer-flatness data obtained at the measurement points and without any influence of rise/sink of the XY-stage 18, is stored in the storage device 36 in association with the XY-coordinates of the corresponding measurement points in an appropriate form, such as a look-up table.

If the predetermined measurement points for the wafer-flatness measurement are denser than those for the measurement for the displacement characteristic of the stage, the material support 20 will be positioned in the process of the wafer-flatness measurement to such positions for which the displacement data in the storage device 36 contains no displacement value of the material support 20 in the Z-direction. In this case, the main control unit 16 derives the displacement value corresponding to the XY-coordinates of such position, through a real-time arithmetic operation, from the displacement values corresponding to the measurement points adjacent to such position. The arithmetic operation may utilize an appropriate interpolation technique, such as approximate functional interpolation, linear interpolation and spline interpolation. Then, the displacement value thus derived is used as the correction amount, such that the drive unit 22 is so controlled as to adjust the position of the material support 20 in the Z-direction to correct for the displacement, and thereby prevent the rise/sink of the XY-stage 18 from affecting the position of the material support 20 in the Z-direction.

As will be clearly understood from the above description, in the disclosed embodiment, the stage apparatus of the present invention comprises the wafer stage 12, the movable mirrors 24, the laser interferometers 26, the drive unit 22, the main control unit 16 and the storage device 36. The main control unit 16 constitutes an arithmetic operation device, while the combination of the drive unit 22 and the main control unit 16 constitute an adjustor for adjusting the position of the XY-stage 18 and/or the material support 20.

As described above, with the projection exposure apparatus 10 according to the disclosed embodiment, any displacement (or rise/ sink) of the material support 20 in the Z-direction as caused by the movement of the XY-stage 18 (and thus of the material support 20) in the X-direction and/or the Y-direction, due to irregularities in the nominally flat guiding surface for the XY-stage or other causes, may be corrected for based on the data in the storage device 36 when the XY-stage 18 (and the material support 20) is moved. Therefore, when the wafer-flatness measurement process is performed, the wafer-flatness may be measured by the focus detection system (32, 34) after the necessary correction to the position of the material support 20 at each measurement point, so that the wafer-flatness can be measured with higher accuracy. This effectively allows to meet severer precision requirements for accuracy in the wafer-flatness measurement, which are expected with respect to future microminiaturization of semiconductor devices.

The disclosed embodiment has been described specifically with reference to the wafer-flatness measurement; however, the application of the present invention is not limited thereto. In fact, the stage apparatus of the present invention may be used to improve measurement accuracy in any of the measurement processes in which the positions of the moving stage are used as the reference for the measurement. For example, in the measurement process where the results of a test exposure are used to measure any of various aberrations with the projection optical system (such as variation in depth of focus, curvature of image plane, tilt of image plane and others), the stage apparatus of the present invention may be used to adjust the position of the wafer surface in the direction along the optical axis of the projection optical system, so as to improve the measurement accuracy. Thus, the stage apparatus of the present invention may be advantageously used with lens inspection equipment, implemented as a projection optical apparatus, to which a projection optical system may be detachably attached.

Further, the stage apparatus of the present invention may be desirably used with a pattern inspection apparatus in which the coordinates of the position of a pattern formed on a reticle are measured using the positions of the moving stage as the reference for the measurement. In addition, it may be desirably used with a laser beam machining apparatus for repairing defective memory chips by breaking fusible links therein to replace defective circuit elements with redundant circuit elements.

Although in the disclosed embodiment the X-stage and the Y-stage are driven through the drive mechanisms having mechanical connections and including a feed screw engaging the corresponding stage and an electric motor for rotating the feed screw, any other types of drive mechanisms may be used as well, including those having nonmechanical connections. For example, a drive mechanism of noncontact type and thus having no mechanical connection at all may be used. One example of such noncontact-type drive mechanism uses a pair of air guides running on respective rails mounted on a base, and the Y-stage (or alternatively the X-stage) is mounted on the air guides and driven by a stepping motor. Further, a linear motor may be used in place of the stepping motor. When a linear motor is used for this purpose, the linear motor may comprise a number of solenoids mounted on the base and arranged in line along the rails for the air guides, and permanent magnets mounted on the air guides and disposed to face the solenoids. Any arrangements for driving the X- and Y-stages to move in the X- and Y-directions, respectively, may be also used, and such arrangements may include other types of noncontact-type driving mechanisms.

Wafers are sometimes finished with chemical mechanical planarization and/or chemical mechanical polishing so as to have surfaces of very high flatness. When such a wafer with highly flattened or planarized surfaces is measured for its flatness, it is expected that the wafer surface would prove itself to be a completely flat and uniform surface. However, there may be possibly foreign bodies such as dust particles between the under surface of the wafer and the top surface of the stage, so that nonuniformity in the wafer surface may be indicated by the results of the flatness measurement. This means that performing the flatness measurement on a highly flattened wafer may indicate any foreign bodies between that wafer and the underlying stage. Thus, in the case where some foreign bodies have adhered to the under surface of a wafer or the top surface of the stage during wafer changes with the stage, the presence of such foreign bodies may be checked during the wafer-flatness measurement process performed prior to the exposure process on that wafer. If the presence of such foreign bodies is actually indicated, they can be removed before the exposure process. Accordingly, a stable exposure process without any influence of foreign bodies may be ensured thereby.

In addition, while the disclosed embodiment has been specifically described with reference to the stage for carrying a wafer thereon used in an exposure apparatus of the step-and-repeat type, the present invention may be also used with an exposure apparatus of any scanning type, in which both a reticle stage carrying a reticle and a wafer stage carrying a wafer are moved in synchronism for making a scanning projection exposure for transferring the pattern formed on the reticle onto the wafer. When used with such an exposure apparatus, the present invention may be applied to the wafer stage as with the disclosed embodiment, as well as to the reticle stage.

In the disclosed embodiment, the data stored in the storage device and/or the data derived therefrom through arithmetic operation using an interpolation technique, is used to perform the real-time adjustment (or correction) operation to adjust (or correct) the position of the material support in the Z-direction prior to each reading of the measured value during the measurement process. Alternatively, as commonly done, the wafer-flatness measurement or other measurement processes may be completed to obtain all the measured values and then correction may be effected to the measured values based on the displacement data stored in the storage device, In this manner, the wafer-flatness measurement may be performed with high accuracy as well.

As apparent from the above, the present invention provides an excellent advantage that the measurement accuracy may be improved in various measurement processes in which the positions of the moving stage are used as the reference for the measurement.

The stage apparatus of the present invention may further comprise an adjustor for adjusting, while the first stage is moved, the position of the material support in the direction along the first axis, depending on the amount of such displacement of the material support in the direction along the first axis that is indicated by the displacement data and that corresponds to the current position of the material support. Such a stage apparatus provides not only the above advantages but also the capability of correcting for rise/sink of the stage during a measurement process.

The stage apparatus of the present invention may further comprise an arithmetic operation device for performing interpolation on the displacement data in the storage to derive the amount of such displacement of the material support in the direction along the first axis that corresponds to the current position of the material support, when the first stage has been moved to such a position for which the displacement data in the storage contains no indication of displacement. Such stage apparatus may further improve the measurement accuracy for various measurement processes in which the positions of the moving stage is used as the reference for the measurement.

The stage apparatus of the present invention may be provided for a projection optical apparatus, in which a master matrix of a pattern is illuminated with an exposure light beam so that an image of the pattern on the master matrix is projected through an projection optical system onto a photosensitized substrate. In this case, the stage apparatus may be used as a stage for positioning a photosensitized substrate, so that various measurement processes using the positions of the moving stage as the reference for the measurement, such as the flatness measurement of a photosensitized substrate, may be performed with improved accuracy.

Having described the present invention with reference to preferred embodiments thereof, it is to be understood that the present invention is not limited to the disclosed embodiments, but may be embodied in various other forms without departing from the spirit and the scope of the present invention as defined by the appended claims.

The entire disclosure of Japanese Patent Application No. HEI 8-353269 (353269/1996) filed on December 16, 1996 including specification, claims, drawings and summary is incorporated herein by reference in its entirety.

## Claims

1. A stage apparatus comprising:
a first stage movable in two orthogonal directions in a predetermined plane;
a material support mounted on said first stage and capable of minute displacement in the direction along a first axis perpendicular to said predetermined plane;
a measuring device which measures coordinates of the position of said material support mounted on said first stage in said two orthogonal directions; and
a storage which stores displacement data indicative of displacement of said material support in the direction along said first axis, as caused by movement of said first stage, in association with coordinates of corresponding position of said material support.

2. A stage apparatus according to claim 1, wherein:
said displacement data stored in said storage is derived by arithmetic operation from distance data indicative of distance of a surface of a plane-parallel surface-mirror placed on said material support from a predetermined reference point, as measured in the direction along said first axis at each of measurement points while said first stage is moved with step intervals in said predetermined plane.

3. A stage apparatus according to claim 1, further comprising:
an adjustor which adjusts, while said first stage is moved, the position of said material support in the direction along said first axis, depending on the amount of such displacement of said material support in the direction along said first axis that is indicated by said displacement data and that corresponds to the current position of said material support.

4. A stage apparatus according to claim 1, further comprising:
an arithmetic operation device for performing interpolation on said displacement data in said storage to derive the amount of such displacement of said material support in the direction along said first axis that corresponds to the current position of said material support, when said first stage has been moved to such a position for which said displacement data in said storage contains no indication of displacement.

5. A projection optical apparatus comprising:
a stage apparatus which supports a substrate;
a mask having a pattern formed thereon;
an illumination system which illuminates said mask with an exposure light beam; and
a projection optical system which projects said pattern formed on said mask onto said substrate with said exposure light beam,
said stage apparatus having:
a first stage movable in two orthogonal directions in a predetermined plane;
a material support which supports a substrate, said material support being mounted on said first stage and capable of minute displacement in the direction along a first axis perpendicular to said predetermined plane;
a measuring device which measures coordinates of the position of said material support mounted on said first stage in said two orthogonal directions; and
a storage which stores displacement data indicative of displacement of said material support in the direction along said first axis, as caused by movement of said first stage, in association with coordinates of corresponding position of said material support.

6. A stage apparatus comprising:
a stage;
a driver which drives said stage for movement in a first direction in a predetermined plane; and
a second measuring device which measures displacement of said stage in a second direction perpendicular to said predetermined plane as caused by movement of said stage in said first direction.

7. A stage apparatus according to claim 6, further comprising:
a first measuring device which measures coordinate of the position of said stage in said first direction; and
a storage which stores displacement data indicative of displacement of said stage in said second direction in association with coordinate of corresponding position of said stage in said first direction, said displacement of said stage being caused by movement of said stage in said first direction.

8. A stage apparatus according to claim 7, wherein:
displacement of said stage in said second direction is derived by arithmetic operation from distance data indicative of distance of a surface of a plane-parallel mirror placed on said stage from a predetermined reference point, as measured in said second direction at each of measurement points.

9. A stage apparatus according to claim 7, further comprising:
an adjustor which adjusts, while said stage is moved in said first direction, the position of said stage in said second direction, depending on the amount of displacement of said stage in said second direction.

10. A stage apparatus according to claim 7, further comprising:
an arithmetic operation system which performs interpolation on said displacement data in said storage to derive the amount of such displacement of said stage in said second direction that corresponds to the current position of said stage in said first direction, when said stage has been moved to such a position for which said displacement data in said storage contains no indication of displacement.

11. A method of moving a stage, comprising the steps of:
moving a stage in a predetermined plane;
measuring displacement of said stage in the direction perpendicular to said predetermined plane as caused by movement of said stage in said predetermined plane; and
correcting displacement characteristic of said stage moved in said predetermined plane based on said measured displacement.

12. A method of moving a stage, comprising the steps of:
moving a stage in two orthogonal directions in a predetermined plane, said stage having a material support mounted thereon for minute displacement in the direction along a first axis perpendicular to said predetermined plane;
measuring coordinates of the position of said material support on said stage in said two orthogonal directions;
measuring displacement of said material support in the direction along said first axis as caused by movement of said stage in said two orthogonal directions;
storing in a storage said measured displacement in association with coordinates of corresponding position of said material support in said two orthogonal directions.

13. An exposure apparatus comprising:
a stage apparatus which supports a photosensitized substrate placed thereon;
a mask having a pattern formed thereon;
an illumination system which illuminates said mask with an exposure light beam; and
a projection optical system which projects said pattern of said mask onto said photosensitized substrate with said exposure light beam,
said stage apparatus comprising:
a stage;
a driver which drives said stage for movement in a first direction in a predetermined plane; and
a second measuring device which measures displacement of said stage in a second direction perpendicular to said predetermined plane.

14. An exposure apparatus according to claim 13, further comprising:
a first measuring device which measures coordinate of the position of said stage in said first direction; and
a storage coupled to said first measuring device and said second measuring device,
said storage storing displacement of said stage in said second direction in association with coordinate of corresponding position of said stage in said first direction, said displacement of said stage being caused by movement of said stage in said first direction.

15. An exposure method, comprising the steps of:
moving a stage in a predetermined plane, said stage supporting a photosensitized substrate placed thereon;
measuring displacement of said stage in the direction perpendicular to said predetermined plane as caused by movement of said stage in said predetermined plane; and
controlling the position of said stage in the direction perpendicular to said predetermined plane based on said measured displacement, for making a projection of a pattern formed on a mask onto said photosensitized substrate with an exposure light beam.

16. An exposure method according to claim 15, further comprising the steps of:
measuring coordinates of the position of said stage in said predetermined plane; and
storing in a storage said measured coordinates and said measured displacement in association with each other.

17. An exposure method according to claim 15, further comprising the step of:
adjusting the position of said stage in the direction perpendicular to said predetermined plane based on said measured displacement of said stage in the direction perpendicular to said predetermined plane, when said stage is moved in said predetermined plane.
